# EUROPÄISCHE PATENTSCHRIFT

(11) **EP 3 923 010 B1**
(45) Veröffentlichungstag und Bekanntmachung des Hinweises auf die Patenterteilung: **03.07.2024**
(21) Anmeldenummer: 21176785.0
(22) Anmeldetag: 31.05.2021
(51) Int. Cl.: G01R 31/52

(54) **SCHUTZKONTAKTSTECKDOSE UND VERFAHREN ZUR ISOLATIONSFEHLERLOKALISIERUNG IN EINEM UNGEERDETEN STROMVERSORGUNGSSYSTEM MIT ISOLATIONSÜBERWACHUNG**
EARTHED SOCKET AND METHOD FOR INSULATION FAULT LOCALIZATION IN AN UNEARTHED POWER SUPPLY SYSTEM WITH INSULATION MONITORING
PRISE DE COURANT DE SÉCURITÉ ET PROCÉDÉ DE LOCALISATION DES DÉFAUTS D'ISOLATION DANS UN SYSTÈME D'ALIMENTATION ÉLECTRIQUE NON MIS À LA MASSE AVEC SURVEILLANCE D'ISOLATION

(30) Priorität: 04.06.2020 DE 102020114906
(43) Veröffentlichungstag der Anmeldung: 15.12.2021
(73) Patentinhaber: Bender GmbH & Co. KG, 35305 Grünberg (DE)
(72) Erfinder: BECKER, Pascal, 35305 Grünberg (DE); SCHEPP, Karl, 35447 Reiskirchen (DE)
(74) Vertreter: advotec.

(56) Entgegenhaltungen:
- EP-A2- 2 574 939
- DE-U1-202005 018 741

## Beschreibung

Die Erfindung betrifft eine Schutzkontaktsteckdose zur Isolationsfehlerlokalisierung und ein Verfahren zur Isolationsfehlerlokalisierung in einem ungeerdeten Stromversorgungssystem mit Isolationsüberwachung durch ein normgemäßes Isolationsüberwachungsgerät, welches zur Bestimmung eines Isolationswiderstands des ungeerdeten Stromversorgungssystems dem ungeerdeten Stromversorgungssystem eine Messspannung überlagert.

Um eine hohe Verfügbarkeit und Betriebssicherheit der elektrischen Stromversorgung sicherzustellen, kommt die Netzform eines ungeerdeten Stromversorgungssystems zum Einsatz, die auch als isoliertes Netz (Isolé Terre - IT) oder als IT-Netz bezeichnet wird.

Bei dieser Art des Stromversorgungssystems sind die aktiven Teile des IT-Netzes von dem Erdpotential getrennt - gegen Erde isoliert - oder über eine hochohmige Impedanz mit Erde verbunden. Die Körper (leitfähige Gehäuse) der an das IT-Netz angeschlossenen Verbraucher sind einzeln oder gemeinsam mittels eines Schutzleiters mit dem Erdpotential verbunden (geerdet).

Der Vorteil der IT-Netze liegt darin, dass bei einem Isolationsfehler (erster Fehler), wie beispielsweise einem Erdschluss oder einem Körperschluss, die Funktion der angeschlossenen Verbraucher nicht beeinträchtigt wird, da sich wegen des im Idealfall unendlich großen Impedanzwertes zwischen einem aktiven Leiter des IT-Netzes und Erde kein geschlossener Fehlerstromkreis ausbilden kann. Durch diese inhärente Sicherheit kann somit eine kontinuierliche Stromversorgung der von dem ungeerdeten Stromversorgungssystem gespeisten Verbraucher auch dann gewährleistet werden, wenn ein erster Isolationsfehler auftritt. Insbesondere in medizinisch genutzten Bereichen findet daher diese Netzform Verwendung.

Der Widerstand des ungeerdeten Stromversorgungssystems gegen Erde muss daher ständig überwacht werden, da durch einen möglichen weiteren Fehler an einem anderen aktiven Leiter (zweiter Fehler) eine Fehlerschleife entstünde und der dabei fließende Fehlerstrom in Verbindung mit einer Überstromschutzeinrichtung eine Abschaltung der Anlage mit Betriebsstillstand zur Folge hätte.

Die Überwachung des ungeerdeten Stromversorgungssystems erfolgt gemäß der Norm IEC61557-8 mit einem Isolationsüberwachungsgerät (IMD), das zwischen mindestens einem der aktiven Leiter des ungeerdeten Stromversorgungssystems und Erde angekoppelt wird und dem ungeerdeten Stromversorgungssystem eine Messspannung überlagert, sodass sich ein dem Isolationsfehler entsprechender Messstrom einstellt, dessen Größenordnung im µA-Bereich liegt.

Unter der Voraussetzung, dass der Isolationszustand des ungeerdeten Stromversorgungssystems daher kontinuierlich von dem Isolationsüberwachungsgerät überwacht wird, kann das ungeerdete Stromversorgungssystem auch bei einem aufgetretenen ersten Fehler ohne vorgeschriebene Zeitlimitierung weiterbetrieben werden, jedoch gilt die Empfehlung, den ersten Fehler so schnell wie praktisch möglich zu beseitigen.

Ist in einem ersten Schritt ein Isolationsfehler von dem Isolationsfehlerüberwachungsgerät erkannt worden, startet in einem zweiten Schritt die Isolationsfehlersuche, indem ein Prüfgerät oder das Isolationsüberwachungsgerät mit einem Prüfstromgenerator einen Prüfstrom in das IT-Netz einspeist. Dieser Prüfstrom, der im Hinblick auf eine zuverlässige Detektion in der Regel größer als der Messstrom ist und einige Milliampere betragen kann, wird von allen Messstromwandlern, die in einem fehlerbehafteten Leitungsabgang (Zweig) des ungeerdeten Stromversorgungssystems liegen, erfasst und in einer Auswerteelektronik eines Isolationsfehlerauswertegerätes ausgewertet sowie in einer Signalisierungseinrichtung angezeigt. Durch die Zuordnung der Messstromwandler zu einem Stromkreis bzw. Leitungsabgang kann der Fehlerort lokalisiert werden.

Diese dem allgemeinen Stand der Technik entsprechende Lösung weist jedoch mehrere Nachteile auf.

Zum einen sind die Messstromwandler nur dem jeweiligen Leitungsabgang des ungeerdeten Stromversorgungssystems zugeordnet und nicht den einzelnen Anschlussmöglichkeiten (Steckdosen) für die Verbraucher.

Zum anderen vergeht bis zur Signalisierung des fehlerbehafteten Leitungsabgangs eine oftmals zu lange Zeitspanne, die sich vorrangig aus der Messzeit des Isolationsüberwachungsgeräts und aus der Messzeit der darauffolgend in Betrieb genommenen Isolationsfehlersucheinrichtung sowie der Dauer bis zur Wahrnehmung eines Alarmsignals an einer Signalisierungseinrichtung - die sich in der Regel in einiger Entfernung zu einer Steckdose befindet - zusammensetzt. Wird also beispielsweise ein fehlerhafter Verbraucher durch Einstecken der Verbraucherzuleitung in eine Steckdose in einem Operationssaal in Betrieb genommen, kann es in der Praxis bis zu 60 Sekunden oder länger dauern, bevor das medizinische Personal über eine optische Anzeige oder ein akustisches Signal informiert wird, dass in dem betreffenden Leitungsabgang oder bei einem in diesem Zweig angeschlossenen Verbraucher ein Isolationsfehler vorliegt. Eine schnelle Zuordnung des Isolationsfehlers zu einem bestimmten Verbraucher ist dann oft nicht mehr möglich. In der Regel muss der fehlerhafte Verbraucher dann durch eine aufwändige manuelle Isolationsfehlersuche von einer Elektrofachkraft ermittelt werden.

Die Gebrauchsmusterschrift DE 20 2005 018 741 U1 zeigt eine Einrichtung zur Ortung von Isolationsfehlern in isolierten ungeerdeten Wechselspannungsnetzen mit einem Prüfspannungsgenerator und mit der Erfassung eines Prüfstroms durch Anordnung von Differenzstromwandlern in jedem Netzabgang zum Einbau in Schaltverteilern mit Profilschienen.

In den Offenlegungsschriften DE 102011083792 A1 bzw. EP 2 574 939 A2 wird ein Isolationsfehlersuchgerät beschrieben, das eine direkte Zuordnung zu einem Verbraucher ermöglicht. Aber auch dabei ist neben dem von dem Isolationsüberwachungsgerät veranlassten Messstrom zur Isolationswiderstandsbestimmung (erster Schritt) noch die anschließende Einspeisung eines Prüfstroms zur Isolationsfehlersuche (zweiter Schritt) erforderlich. Der Isolationswiderstandsmessung wird zeitlich nachgeschaltet ein Prüfstrom in das ungeerdete Stromversorgungsnetz eingespeist, der an einer Schutzkontaktsteckdose von einem Messstromwandler erfasst werden kann. In diesem Fall liegen die Erkennungszeiten für einen fehlerbehafteten Verbraucher immer noch im Bereich von ca. 10 Sekunden. Ein Verfahren, welches nahezu in Echtzeit, also unmittelbar bei Einstecken des Verbraucheranschlusses in die Steckdose, eine Signalisierung ermöglicht, ist zurzeit nicht bekannt.

Der vorliegenden Erfindung liegt somit die Aufgabe zugrunde, eine Vorrichtung und ein Verfahren zu entwerfen, welche eine möglichst schnelle und zuverlässige Erkennung und Signalisierung eines mit einem Isolationsfehler behafteten Verbrauchers unmittelbar an der Anschlussstelle des Verbrauchers signalisieren.

Diese Aufgabe wird erfindungsgemäß gelöst durch eine Schutzkontaktsteckdose zur Isolationsfehlerlokalisierung, umfassend ein Gehäuse mit elektrischen Kontakten, eine Signalisierungseinrichtung zur Signalisierung eines Isolationszustands und eine Strommesseinrichtung zur Erfassung und Auswertung eines Differenzstroms, wobei die Strommesseinrichtung einen Messstromwandler und eine Auswerteelektronik aufweist und zur hochauflösenden Erfassung und Auswertung eines von der Messspannung getriebenen Messstroms als Mess-Differenzstrom ausgelegt ist.

Der Grundgedanke der vorliegenden Erfindung beruht in vorteilhafter Weise darauf, den vorhandenen von dem normgemäß vorgeschriebenen Isolationsüberwachungsgerät zum Zweck der Isolationswiderstandsbestimmung bewirkten Messstrom - statt eines eigens erzeugten Prüfstroms - hochauflösend als Mess-Differenzstrom direkt in einer Steckdose zum Zweck der Isolationsfehlerlokalisierung zu erfassen und auszuwerten.

Das vorgeschriebene Isolationsüberwachungsgerät - welches nicht Bestandteil der Erfindung ist - muss normgemäß Anforderungen hinsichtlich seines Innenwiderstands und an die Höhe der Messspannung erfüllen, sodass sich daraus ein maximaler Messstrom ergibt, dessen Größe im µA-Bereich (Mikroampere-Bereich) liegt.

Durch die erfindungsgemäße Verwendung einer hochempfindlichen Strommesseinrichtung im µA-Bereich, bestehend aus einem Messstromwandler und einer Auswerteelektronik, ist eine kontinuierliche Überwachung des Messstroms des Isolationsüberwachungsgeräts möglich.

Der von der Messspannung des Isolationsüberwachungsgeräts getriebene Messstrom wird als Mess-Differenzstrom von dem Messstromwandler erkannt und ermöglicht nach der Auswertung und Signalisierung eine sofortige Aussage über einen Isolationsfehler.

Beispielsweise wird eine Erhöhung des Messstroms von 10 µA auf 50 µA nach dem Anschließen eines fehlerbehafteten Verbrauchers in der vorzugsweise Mikroprozessor-basierten Auswerteelektronik erkannt und führt zu einer sofortigen Signalisierung eines verschlechterten Isolationszustands durch ein optisches und/oder akustisches Signal.

Durch die sofortige hochauflösende Erfassung und Auswertung des Messstroms unmittelbar an der Anschlussstelle (Steckdose) des Verbrauchers entfällt die Notwendigkeit der Einspeisung eines separaten Prüfstroms nach der Erkennung eines Isolationsfehlers. Eine zeitaufwändig durchgeführte Isolationsfehlersuche mit automatischen oder manuellen Isolationsfehlersucheinrichtungen ist nicht erforderlich.

Zudem besteht eine erhöhte elektrische Sicherheit, da durch den Verzicht auf Prüfströme im mA-Bereich (Milliampere-Bereich) die Gefahr einer Störung von hochsensiblen Sensoren in dem Stromversorgungssystem verringert wird und somit die Akzeptanz einer selektiven Isolationsüberwachung auch in einer kritischen Systemumgebung erhöht ist.

Dies hat weiterhin den Vorteil, dass medizinische Bereiche für die Dauer einer üblichen Isolationsfehlersuche nicht komplett freigehalten werden müssen.

Erfindungsgemäß ist die Strommesseinrichtung weiter zur Erfassung und Auswertung eines mit der Netzfrequenz des ungeerdeten Stromversorgungssystems fließenden Fehlerstroms als Fehler-Differenzstrom ausgeführt.

Neben der hochauflösenden Erfassung und Auswertung des von der Messspannung getriebenen Messstroms als Mess-Differenzstrom ist die Strommesseinrichtung in der Lage, bei einem ungeerdeten Wechselspannungs-Stromversorgungssystem einen von einer Netzspannung dieses Systems mit der Netzfrequenz verursachten Fehlerstrom als Fehler-Differenzstrom zu erfassen und auszuwerten.

Da in dem ungeerdeten Stromversorgungssystem bei einem unsymmetrischen Isolationsfehler über die stets vorhandenen Ableitkapazitäten ein Ableitstrom fließt, kann dieser Fehlerstrom als Fehler-Differenzstrom von dem Messstromwandler erfasst werden. Eine Änderung dieses Fehler-Differenzstroms infolge des Anschlusses eines fehlerbehafteten Verbrauchers wird von der Strommesseinrichtung sehr schnell (innerhalb weniger als eine Sekunde) erfasst und kann durch ein optisches und/oder akustisches Signal von der Signalisierungseinrichtung dargestellt werden.

Mit Vorteil ist die Strommesseinrichtung allstromsensitiv ausgeführt.

Diese Ausgestaltung erlaubt die Erfassung und Auswertung von (glatten) Gleichfehlerströmen, pulsierenden Gleichfehlerströmen und Wechselfehlerströmen insbesondere in ungeerdeten Gleichspannungs-Stromversorgungssystemen und ungeerdeten Stromversorgungssystemen mit Umrichterbetrieb.

Weiterhin weist die Strommesseinrichtung eine Testschleife auf, die durch den Messstromwandler zur Erzeugung eines Teststroms geführt ist.

In der Strommesseinrichtung wird ein Teststrom erzeugt, der dem Messstrom des Isolationsüberwachungsgeräts entspricht und mit dem die korrekte Funktionsweise der Differenzstromerfassung geprüft wird.

Mit Vorteil ist die Auswerteelektronik zur Bewertung des Mess-Differenzstromverlaufs ausgelegt, um eine synchrone Isolationsfehler-Signalisierung zwischen dem Isolationsüberwachungsgerät und der Schutzkontaktsteckdose zur Isolationsfehlerlokalisierung zu bewirken.

Das Isolationsüberwachungsgerät und die in der erfindungsgemäßen Schutzkontaktsteckdose zur Isolationsfehlerlokalisierung angeordnete Signalisierungseinrichtung zur Signalisierung des Isolationszustands sind in der Regel entfernt voneinander installiert.

Dem Stand der Technik gemäß müsste zur Synchronisierung der Isolationsfehleranzeige eine Kommunikation über eine Datenschnittstelle, wie beispielsweise PowerLine, RS485 oder MODBUS, erfolgen. Dies ist in nachteiliger Weise sehr kostenintensiv und würde zusätzliche Installationsmaßnahmen erfordern.

Demgegenüber ermöglicht die synchrone Isolationsfehler-Signalisierung eine zeitgleiche Darstellung eines Isolationsfehlers in der erfindungsgemäßen Schutzkontaktsteckdose und dem Isolationsüberwachungsgerät.

Das Bewerten des Mess-Differenzstromverlaufs zur synchronen Isolationsfehler-Signalisierung erfolgt vorzugsweise durch Erkennen einer Amplitudenänderung des Mess-Differenzstroms.

Alternativ dazu erfolgt das Bewerten des Mess-Differenzstromverlaufs durch Erkennen einer Musteränderung des Mess-Differenzstroms.

Indem also der zeitliche Verlauf des als Mess-Differenzstrom von dem Messstromwandler erfassten Messstroms in der Auswerteelektronik beispielsweise mittels einer Schwellwertbetrachtung oder einer Korrelationsberechnung ausgewertet wird, erhält die erfindungsgemäße Schutzkontaktsteckdose von dem Isolationsüberwachungsgerät eine Information darüber, ob ein Isolationsfehler vorliegt.

In vorteilhafter Weise ist die erfindungsgemäße Schutzkontaktsteckdose als fest installierte Steckdose, als mobile Leitungskupplung (Mehrfachsteckdose) oder als Zwischenstecker (Adapter) ausgeführt.

Indem die erfindungsgemäße Schutzkontaktsteckdose zur Isolationsfehlerlokalisierung unmittelbar an dem Ort installiert ist, an dem der in Betrieb zu nehmende Verbraucher angeschlossen wird - der Anschlussstecker eingesteckt wird - erkennt das medizinische Personal mittels der Signalisierungseinrichtung sofort, ob ein Isolationsfehler an dem Verbraucher vorliegt. Die oben beschriebene Erhöhung des Messstroms von beispielsweise 10 µA auf 50 µA nach dem Einstecken der Verbraucherzuleitung führt zu einer sofortigen Signalisierung des Isolationszustands an der entsprechenden Steckdose.

Die Schutzkontaktsteckdose kann dabei als fest installierte Wandsteckdose oder als Zwischenstecker in Form eines aufsteckbaren Adapters ausgeführt sein. Weiterhin ist auch eine Ausführung als Leitungskupplung in Form einer Mehrfachsteckdose mit mehreren erfindungsgemäßen Schutzkontaktsteckdosen, beispielsweise als Ausstattung eines Gerätewagens, vorgesehen.

Die zuvor beschriebene erfindungsgemäße Schutzkontaktsteckdose zur Isolationsfehlerlokalisierung beruht auf der in dem unabhängigen Verfahrensanspruch 6 beschriebenen technischen Lehre. Insoweit treffen auch die vorgenannten technischen Wirkungen und daraus entstehenden verfahrenstechnischen Vorteile auf die Verfahrensmerkmale zu.

Weitere vorteilhafte Ausgestaltungsmerkmale ergeben sich aus der nachfolgenden Beschreibung und den Zeichnungen, die bevorzugte Ausführungsformen der Erfindung anhand von Beispielen erläutern.

Es zeigen:
- **Fig. 1**: ein funktionales Blockdiagramm einer erfindungsgemäße Schutzkontaktsteckdose zur Isolationsfehlerlokalisierung ,
- **Fig. 2**: eine erfindungsgemäße Schutzkontaktsteckdose als fest installierte Steckdose,
- **Fig. 3**: eine erfindungsgemäße Schutzkontaktsteckdose als Zwischenstecker,
- **Fig. 4**: eine erfindungsgemäße Schutzkontaktsteckdose als mobile Leitungskupplung,
- **Fig. 5**: eine erfindungsgemäße Schutzkontaktsteckdose mit Omega-Symbol als optische Anzeige,
- **Fig. 6**: einen Mess-Differenzstromverlauf mit Amplitudenänderung,
- **Fig. 7**: einen Mess-Differenzstromverlauf mit Musteränderung und
- **Fig. 8**: ein Ablaufdiagramm zur synchronen IsolationsfehlerSynchronisierung.

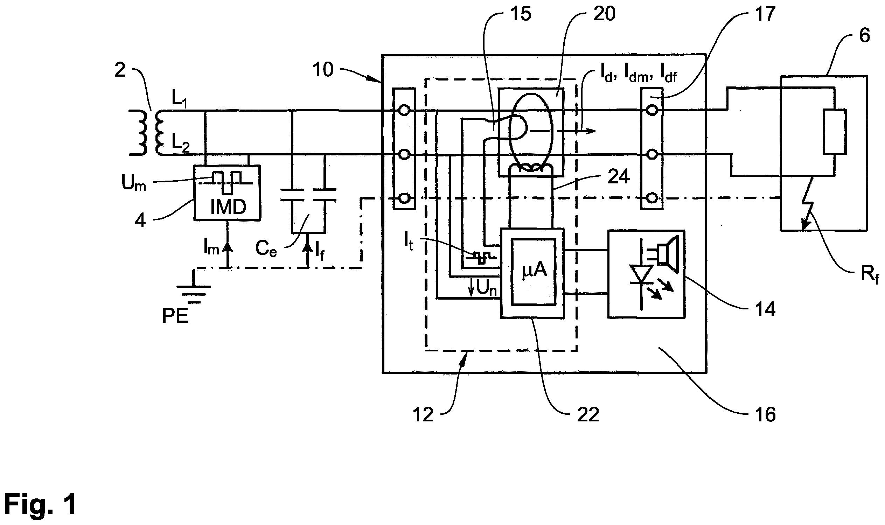

**Fig. 1** zeigt eine erfindungsgemäße Schutzkontaktsteckdose 10 zur Isolationsfehlerlokalisierung in einem ungeerdeten Stromversorgungssystem 2 (IT-Netz), an welches über aktive Leiter L₁, L₂ ein Verbraucher 6 angeschlossen ist.

Zur Bestimmung eines Isolationswiderstands R_{f} (Isolationsfehler) ist zwischen die aktiven Leiter L₁, L₂ und Erde PE ein normgemäßes Isolationsüberwachungsgerät 4 geschaltet, welches dem IT-Netz eine Messspannung Uₘ überlagert. Es stellt sich ein Messkreis mit einem von der Messspannung Uₘ getriebenen Messstrom Iₘ über die aktiven Leiter L₁, L₂, den Isolationswiderstand R_{f} und über den Schutzleiter (Schutzleiterverbindung mit Erde PE) zurück zu dem Isolationsüberwachungsgerät 4 ein. Der Messstrom Iₘ wird in dem Isolationsüberwachungsgerät 4 gemessen und erlaubt eine Aussage über die Größe des Isolationswiderstands R_{f} erlaubt.

Die erfindungsgemäße Schutzkontaktsteckdose 10 umfasst als wesentliche Elemente eine Strommesseinrichtung 12, eine Signalisierungseinrichtung 14 und ein Gehäuse 16 mit Kontakten 17. Die Kontakte 17 sind als Steckkontakte zum Anschließen eines Steckers einer Zuleitung des Verbrauchers 6 ausgeführt.

Die Strommesseinrichtung 12 besitzt einen Messstromwandler 20, der mit einem Ringkern die aktiven Leiter L₁ und L₂ als Primär-"Wicklung" umschließt, sowie eine Auswerteelektronik 22.

Der Messstromwandler 20 erfasst den in dem Messkreis fließenden Messstrom Iₘ, welcher sich als Mess-Differenzstrom I_{dm} in den aktiven Leitern L₁ und L₂ fortsetzt und leitet ein Differenzstrom-Messergebnis über eine Sekundärwicklung 24 an die Auswerteelektronik 22 weiter.

Die Auswerteelektronik 22 wird von einer Netzspannung Uₙ des ungeerdeten Stromversorgungssystems 2 gespeist.

Die Strommesseinrichtung 12 umfasst weiter eine Testschleife 15, mit der ein Teststrom Iₜ durch den Messstromwandler 20 geführt wird, um diesen zu testen.

Bei einem unsymmetrischen Isolationsfehler R_{f} erfasst der Messstromwandler 20 zusätzlich einen Fehlerstrom I_{f} als Fehler-Differenzstrom I_{df}, welcher über die stets vorhandenen Ableitkapazitäten Cₑ des ungeerdeten Stromversorgungssystems 2 fließt.

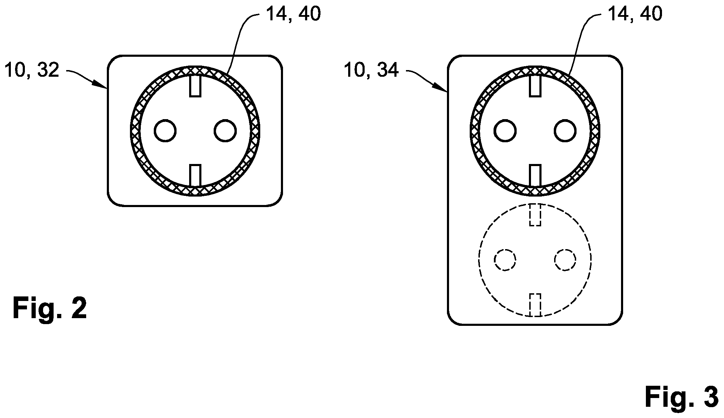

Die folgenden **Fig. 2 bis 5** zeigen verschiedene Ausführungsformen der erfindungsgemäßen Schutzkontaktsteckdose 10. Die jeweiligen Ausführungsformen entsprechen dabei in ihrer äußeren Dimensionierung den Abmessungen einer normgerechten Schutzkontakt-kompatiblen, herkömmlichen Steckdose.

In **Fig. 2** ist die erfindungsgemäße Schutzkontaktsteckdose 10 als fest installierte Steckdose 32, beispielsweise in einem Wandauslass (Wandsteckdose) oder für eine Kabelkanalinstallation, ausgeführt. Die Signalisierungseinrichtung 14 ist hier als optische Anzeige 40 in Form eines leuchtenden LED-Rings ausgeführt. Der LED Ring kann beispielsweise grün aufleuchten, falls kein Isolationsfehler lokalisiert ist, und wechselt zu gelb, sobald ein Isolationsfehler lokalisiert ist.

**Fig. 3** zeigt die Ausführung der erfindungsgemäßen Schutzkontaktsteckdose 10 als Zwischenstecker 34 für eine handelsübliche Steckdose. Damit ist eine einfache nachträgliche Installation der erfindungsgemäßen Schutzkontaktsteckdose 10 zur Isolationsfehlerlokalisierung an bestehenden Verbraucheranschlüssen möglich.

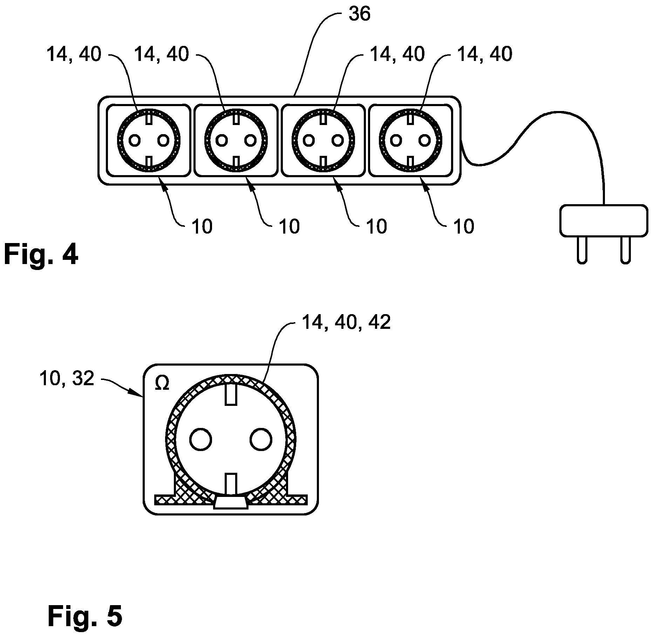

In einer weiteren Ausführungsform nach **Fig. 4** ist die erfindungsgemäße Schutzkontaktsteckdose 10 als mobile Leitungskupplung 36 (Mehrfachsteckdose) ausgeführt. Diese Ausführung ermöglicht eine verbraucherindividuelle Isolationsfehlerlokalisierung, indem für eine oder mehrere der Einsteckmöglichkeiten der Mehrfachsteckdose 36 eine Isolationsfehlerlokalisierung integriert ist.

**Fig. 5** zeigt beispielhaft für die erfindungsgemäße Schutzkontaktsteckdose 10 als fest installierte Steckdose 32 eine Ausführung der Signalisierungseinrichtung 14 als optische Anzeige 40 in Form eines Omega-Symbols 42, um diese Steckdose als erfindungsgemäße Schutzkontaktsteckdose 10, 32 mit Isolationsfehlerlokalisierung zu kennzeichnen und damit von herkömmlichen Steckdosen ohne Isolationsfehlerlokalisierung zu unterscheiden.

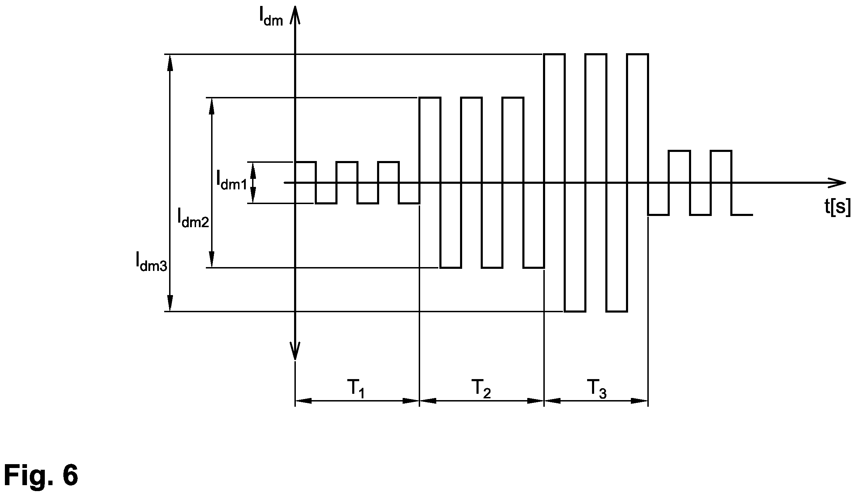

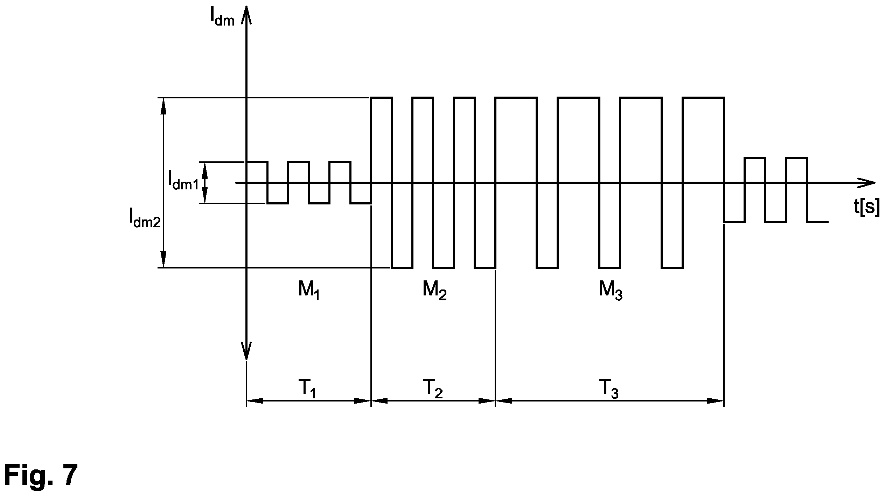

Die **Fig. 6 bis 8** erläutern den Ablauf der Auswertung des Differenzstrom-Messergebnisses in der Auswerteelektronik 22 durch die Bewertung des Mess-Differenzstromverlaufs I_{dm}, um die Isolationsfehler-Signalisierung zwischen dem Isolationsüberwachungsgerät 4 und der erfindungsgemäßen Schutzkontaktsteckdose 10 zu synchronisieren.

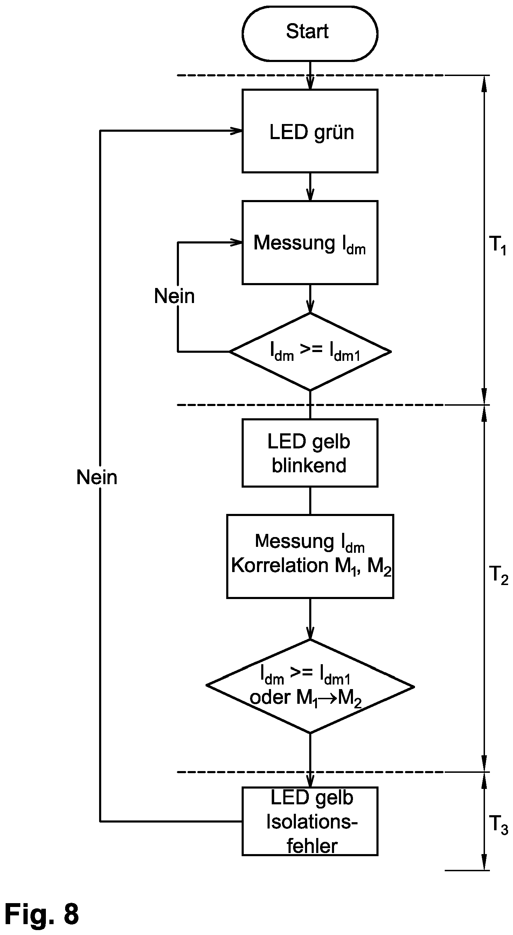

Der von der Messspannung Uₘ getriebene Messstrom Iₘ setzt sich am Ort des Messstromwandlers 20 - in der Steckdose - als Mess-Differenzstrom I_{dm} fort und wird dort in einer Phase T₁ kontinuierlich gemessen. Dabei erfolgt in der Auswerteelektronik 22 eine Prüfung, ob der Mess-Differenzstrom I_{dm} einen für den fehlerfreien Fall geltenden Differenzstromgrenzwert I_{dm1} (Spitze-Spitze-Amplitude) überschreitet. Wird der Differenzstromgrenzwert I_{dm1} in dieser ersten Phase T₁ nicht überschritten, leuchtet die optische Anzeige 40 grün auf **(****Fig. 8****).**

Überschreitet der erfasste Mess-Differenzstrom I_{dm} den Differenzstromgrenzwert I_{dm1}, so wechselt die optische Anzeige 40 in Phase T₂ in eine gelb blinkende Darstellung als Vorwarnung **(****Fig. 8****).**

Sobald das Isolationsüberwachungsgerät 4 - aufgrund seiner längeren Auswertedauer - einen Isolationsfehler in dem ungeerdeten Stromversorgungssystem 2 erkennt, erniedrigt das entsprechend zu programmierende Isolationsüberwachungsgerät 4 seinen Innenwiderstand um einen zulässigen Wert und erhöht damit den Messstrom Iₘ. Der Messstrom Iₘ übersteigt damit als erfasster Mess-Differenzstrom I_{dm} einen zweiten Differenzstromgrenzwert I_{dm2}. Dieser Anstieg (Amplitudenmodulation des Messstroms) in Phase T₃ gilt als Kriterium für eine Isolationsfehlermeldung des Isolationsüberwachungsgeräts 4 und die gelb blinkende optische Anzeige 40 wechselt in eine gelbe Daueranzeige **(****Fig. 8****).**

Alternativ oder ergänzend zu der Amplitudenänderung des Messstroms Iₘ kann der Übergang von der zweiten Phase T₂ zu der dritten Phase T₃ auch durch eine Erkennung einer Musteränderung des Messstroms Iₘ erfolgen (Codierung des Messstroms). Dabei prüft die Auswerteelektronik 22 mittels einer Korrelationsberechnung, ob sich das Muster des Mess-Differenzstromverlaufs I_{dm} von einem Muster M₁ auf ein Muster M₂ geändert hat. Wird eine Musteränderung erkannt, so wechselt die optische Anzeige 40 in Phase T₃ auf eine gelbe Daueranzeige **(****Fig. 8****).**

## Patentansprüche

1. Schutzkontaktsteckdose (10) zur Isolationsfehlerlokalisierung in einem ungeerdeten Stromversorgungssystem (2) mit Isolationsüberwachung durch ein normgemäßes Isolationsüberwachungsgerät (4), welches zur Bestimmung eines Isolationswiderstands (R_{f}) des ungeerdeten Stromversorgungssystems (2) dem ungeerdeten Stromversorgungssystem (2) eine Messspannung (Uₘ) überlagert,
umfassend
ein Gehäuse (16) mit elektrischen Kontakten (17),
eine Signalisierungseinrichtung (14) zur Signalisierung eines Isolationszustands und
eine Strommesseinrichtung (12) zur Erfassung und Auswertung eines Differenzstroms (I_{d}, I_{dm}, I_{df}), wobei die Strommesseinrichtung (12) einen Messstromwandler (20) und eine Auswerteelektronik (22) aufweist,
**dadurch gekennzeichnet,**
**dass** die Strommesseinrichtung (12) zur hochauflösenden Erfassung und Auswertung eines von der Messspannung (Uₘ) getriebenen Messstroms (Iₘ) als Mess-Differenzstrom (I_{d}, I_{dm}) ausgelegt ist und zur Erfassung und Auswertung eines mit einer Netzfrequenz des ungeerdeten Stromversorgungssystems (2) fließenden Fehlerstroms (I_{f}) als Fehler-Differenzstrom (I_{d}, I_{df}) ausgeführt ist.

2. Schutzkontaktsteckdose (10) zur Isolationsfehlerlokalisierung nach Anspruch 1,
**dadurch gekennzeichnet,**
**dass** die Strommesseinrichtung (12) allstromsensitiv ausgeführt ist.

3. Schutzkontaktsteckdose (10) zur Isolationsfehlerlokalisierung nach Anspruch 1 oder 2,
**dadurch gekennzeichnet,**
**dass** die Strommesseinrichtung (12) eine Testschleife (15) aufweist, die durch den Messstromwandler (20) zur Erzeugung eines Teststroms (Iₜ) geführt ist.

4. Schutzkontaktsteckdose (10) zur Isolationsfehlerlokalisierung nach einem der Ansprüche 1 bis 3,
**dadurch gekennzeichnet,**
**dass** die Auswerteelektronik (22) zur Bewertung des Mess-Differenzstromverlaufs (I_{dm}) ausgelegt ist, um eine synchrone Isolationsfehler-Signalisierung zwischen dem Isolationsüberwachungsgerät (4) und der Vorrichtung zur Isolationsfehlerlokalisierung (10) herzustellen.

5. Schutzkontaktsteckdose (10) zur Isolationsfehlerlokalisierung nach einem der Ansprüche 1 bis 4,
**gekennzeichnet durch** eine Ausführung als fest installierte Steckdose (32), als Zwischenstecker (34) oder als mobile Leitungskupplung (36).

6. Verfahren zur Isolationsfehlerlokalisierung in einem ungeerdeten Stromversorgungssystem (2) mit Isolationsüberwachung durch ein normgemäßes Isolationsüberwachungsgerät (4), welches zur Bestimmung eines Isolationswiderstands (R_{f}) des ungeerdeten Stromversorgungssystems (2) dem ungeerdeten Stromversorgungssystem (2) eine Messspannung (Uₘ) überlagert, umfassend die Verfahrensschritte zur Ausführung in einer erfindungsgemäßen Schutzkontaktsteckdose nach einem der Ansprüche 1 bis 6:
Erfassen und Auswerten eines Differenzstroms (I_{d}, I_{dm}, I_{df}) mittels einer Strommesseinrichtung (12), welche einen Messstromwandler (20) und eine Auswerteelektronik (22) aufweist,
Signalisieren eines Isolationszustands mittels einer Signalisierungseinrichtung (14),
wobei ein von der Messspannung (Uₘ) getriebener Messstrom (Iₘ) als Mess-Differenzstrom (I_{d}, I_{dm}) mittels der Strommesseinrichtung (12) hochauflösend erfasst und ausgewertet wird und ein mit einer Netzfrequenz des ungeerdeten Stromversorgungssystems (2) fließender Fehlerstrom (I_{f}) als Fehler-Differenzstrom (I_{d}, I_{df}) mittels der Strommesseinrichtung (12) erfasst und ausgewertet wird.

7. Verfahren zur Isolationsfehlerlokalisierung nach Anspruch 6,
**dadurch gekennzeichnet,**
**dass** das Erfassen und Auswerten mittels der Strommesseinrichtung (12) allstromsensitiv erfolgt.

8. Verfahren zur Isolationsfehlerlokalisierung nach Anspruch 6 oder 7, **gekennzeichnet durch**
Erzeugen eines Teststroms (Iₜ), welcher mittels einer Testschleife (15) durch den Messstromwandler (20) der Strommesseinrichtung (12) geführt wird.

9. Verfahren zur Isolationsfehlerlokalisierung nach einem der Ansprüche 6 bis 8,
**gekennzeichnet durch**
Bewerten des Mess-Differenzstromverlaufs (I_{dm}) mittels der Auswerteelektronik, um eine Isolationsfehler-Signalisierung zwischen dem Isolationsüberwachungsgerät (4) und der Vorrichtung zur Isolationsfehlerlokalisierung (10) zu synchronisieren.

10. Verfahren zur Isolationsfehlerlokalisierung nach Anspruch 9,
**dadurch gekennzeichnet,**
**dass** das Bewerten des Mess-Differenzstromverlaufs (I_{dm}) durch Erkennen einer Amplitudenänderung des Mess-Differenzstroms (I_{dm}) erfolgt.

11. Verfahren zur Isolationsfehlerlokalisierung nach Anspruch 9 oder 10,
**dadurch gekennzeichnet,**
**dass** das Bewerten des Mess-Differenzstromverlaufs (I_{dm}) durch Erkennen einer Musteränderung (M₁, M₂) des Mess-Differenzstroms (I_{dm}) erfolgt.

## Claims

1. A grounded socket (10) for insulation fault location in an ungrounded power supply system (2) including insulation monitoring by a standard insulation monitoring device (4) superimposing a measuring voltage (Uₘ) on the ungrounded power supply system (2) for determining an insulation resistance (Rf) of the ungrounded power supply system (2),
the grounded socket (10) comprising
a housing (16) having electrical contacts (17),
a signaling device (14) for signaling an insulation state, and
a current measuring device (12) for detecting and evaluating a differential current (I_{d}, I_{dm}, I_{df}), the current measuring device (12) having a measuring current transformer (20) and evaluating electronics (22),
**characterized in that**
the current measuring device (12) is configured for high-resolution detection and evaluation of a measuring current (Iₘ) driven by the measuring voltage (Uₘ) as a differential measuring current (I_{d}, I_{dm}) and for detection and evaluation of a fault current (If) flowing at a network frequency of the ungrounded power supply system (2) as a differential fault current (I_{d}, I_{df}).

2. The grounded socket (10) for insulation fault location according to claim 1,
**characterized in that**
the current measuring device (12) is AC/DC-sensitive.

3. The grounded socket (10) for insulation fault location according to claim 1 or 2,
**characterized in that**
the current measuring device (12) has a test loop (15) routed through the measuring current transformer (20) for generating a test current (Iₜ).

4. The grounded socket (10) for insulation fault location according to any one of claims 1 to 3,
**characterized in that**
the evaluating electronics (22) are configured to assess the differential measuring current curve (I_{dm}) in order to establish synchronous insulation fault signaling between the insulation monitoring device (4) and the device for insulation fault location (10).

5. The grounded socket (10) for insulation fault location according to any one of claims 1 to 4,
**characterized by** being realized as a permanently installed socket (32), as an adapter plug (34) or as a mobile line coupler (36).

6. A method for insulation fault location in an ungrounded power supply system (2) including insulation monitoring by a standard insulation monitoring device (4) superimposing a measuring voltage (Uₘ) on the ungrounded power supply system (2) for determining an insulation resistance (Rf) of the ungrounded power supply system (2), the method comprising the method steps to be executed in a grounded socket according to any one of claims 1 to 6 of the invention:
detecting and evaluating a differential current (I_{d}, I_{dm}, I_{df}) by means of a current measuring device (12) having a measuring current transformer (20) and evaluating electronics (22),
signaling an insulation state by means of a signaling device (14), a measuring current (Iₘ) driven by the measuring voltage (Uₘ) being detected and evaluated as a differential measuring current (I_{d}, I_{dm}) in high resolution by means of the current measuring device (12) and a fault current (If) flowing at a network frequency of the ungrounded power supply system (2) being detected and evaluated as a differential fault current (I_{d}, I_{df}) by means of the current measuring device (12).

7. The method for insulation fault location according to claim 6,
**characterized in that**
the detection and evaluation by means of the current measuring device (12) is AC/DC-sensitive.

8. The method for insulation fault location according to claim 6 or 7,
**characterized by** the step of
generating a test current (Iₜ) which is routed through the measuring current transformer (20) of the current measuring device (12) by means of a test loop (15).

9. The method for insulation fault location according to any one of claims 6 to 8,
**characterized by** the step of
assessing the differential measuring current curve (I_{dm}) by means of the evaluating electronics in order to synchronize insulation fault signaling between the insulation monitoring device (4) and the device for insulation fault location (10).

10. The method for insulation fault location according to claim 9,
**characterized in that**
the differential measuring current curve (I_{dm}) is assessed by detecting a change in amplitude of the differential measuring current (I_{dm}) .

11. The method for insulation fault location according to claim 9 or 10,
**characterized in that**
the differential measuring current curve (I_{dm}) is assessed by detecting a change in pattern (M₁, M₂) of the differential measuring current (I_{dm}).

## Revendications

1. Prise Schuko (10) pour la localisation d'un défaut d'isolement dans un système d'alimentation électrique (2) non mis à la terre incluant la surveillance d'isolement par un dispositif de surveillance d'isolement (4) standardisé qui superpose une tension de mesure (Uₘ) au système d'alimentation électrique (2) non mis à la terre pour la détermination d'une résistance d'isolement (Rf) du système d'alimentation électrique (2) non mis à la terre,
la prise Schuko (10) comprenant
un boîtier (16) ayant des contacts électriques (17),
un dispositif de signalisation (14) pour la signalisation d'un état d'isolement, et
un dispositif de mesure de courant (12) pour la détection et pour l'évaluation d'un courant différentiel résiduel (I_{d}, I_{dm}, I_{df}), le dispositif de mesure de courant (12) ayant un transformateur de courant pour mesures (20) et un dispositif de détection électronique (22),
**caractérisée en ce que**
le dispositif de mesure de courant (12) est configuré pour la détection et l'évaluation à haute résolution d'un courant de mesure (Iₘ) actionné par la tension de mesure (Uₘ) comme courant différentiel résiduel de mesure (I_{d}, I_{dm}) et pour la détection et pour l'évaluation d'un courant de défaut (If) s'écoulant à une fréquence de réseau du système d'alimentation électrique (2) non mis à la terre comme courant différentiel résiduel de défaut (I_{d}, I_{df}).

2. Prise Schuko (10) pour la localisation d'un défaut d'isolement selon la revendication 1,
**caractérisée en ce que**
le dispositif de mesure de courant (12) est sensible à tous courants.

3. Prise Schuko (10) pour la localisation d'un défaut d'isolement selon la revendication 1 ou la revendication 2,
**caractérisée en ce que**
le dispositif de mesure de courant (12) a une boucle d'essai (15) acheminée par le transformateur de courant pour mesures (20) pour la génération d'un courant d'essai (Iₜ).

4. Prise Schuko (10) pour la localisation d'un défaut d'isolement selon l'une quelconque des revendications 1 à 3,
**caractérisée en ce que**
le dispositif de détection électronique (22) est configuré pour l'estimation de la courbe de courant différentiel résiduel pour mesures (I_{dm}) afin d'établir une signalisation synchrone de défaut d'isolement entre le dispositif de surveillance d'isolement (4) et le dispositif pour la localisation d'un défaut d'isolement (10).

5. Prise Schuko (10) for localisation d'un défaut d'isolement selon l'une quelconque des revendications 1 à 4,
**caractérisée par** la réalisation comme fiche (32) installée de manière fixe, comme fiche intermédiaire (34) ou comme coupleur de ligne (36) mobile.

6. Procédé pour la localisation d'un défaut d'isolement dans un système d'alimentation électrique (2) non mis à la terre incluant la surveillance d'isolement par un dispositif de surveillance d'isolement (4) standardisé qui superpose une tension de mesure (Uₘ) au système d'alimentation électrique (2) non mis à la terre pour la détermination d'une résistance d'isolement (R_{f}) du système d'alimentation électrique (2) non mis à la terre, le procédé comprenant les étapes de procédé à être effectuées dans une prise Schuko selon l'une quelconque des revendications 1 à 6 dans la présente invention :
la détection et l'évaluation d'un courant différentiel résiduel (I_{d}, I_{dm}, I_{df}) au moyen d'un dispositif de mesure de courant (12) ayant un transformateur de courant pour mesures (20) et un dispositif de détection électronique (22),
la signalisation d'un état d'isolement au moyen d'un dispositif de signalisation (14),
un courant de mesure (Iₘ) actionné par la tension de mesure (Uₘ) étant détecté et évalué à haute résolution comme courant différentiel résiduel de mesure (I_{d}, I_{dm}) au moyen du dispositif de mesure de courant (12) et un courant de défaut (I_{f}) s'écoulant à une fréquence de réseau du système d'alimentation électrique (2) non mis à la terre étant détecté et évalué comme courant différentiel résiduel de défaut (I_{d}, I_{df}) au moyen du dispositif de mesure de courant (12).

7. Procédé pour la localisation d'un défaut d'isolement selon la revendication 6,
**caractérisé en ce que**
la détection et l'évaluation au moyen du dispositif de mesure de courant (12) sont sensibles à tous courants.

8. Procédé pour la localisation d'un défaut d'isolement selon la revendication 6 ou la revendication 7,
**caractérisé par** l'étape de
la génération d'un courant d'essai (Iₜ) qui est acheminé par le transformateur de courant pour mesures (20) du dispositif de mesure de courant (12) au moyen d'une boucle d'essai (15).

9. Procédé pour la localisation d'un défaut d'isolement selon l'une quelconque des revendications 6 à 8,
**caractérisé par** l'étape de
l'estimation de la courbe de courant différentiel résiduel pour mesures (I_{dm}) au moyen du dispositif de détection électronique afin de synchroniser la signalisation de défaut d'isolement entre le dispositif de surveillance d'isolement (4) et le dispositif pour la localisation d'un défaut d'isolement (10).

10. Procédé pour la localisation d'un défaut d'isolement selon la revendication 9,
**caractérisé en ce que**
le courant différentiel résiduel de mesure (I_{dm}) est estimé par la détection d'un change d'amplitude du courant différentiel résiduel de mesure (I_{dm}).

11. Procédé pour la localisation d'un défaut d'isolement selon la revendication 9 ou la revendication 10,
**caractérisé en ce que**
la courbe de courant différentiel résiduel pour mesures (I_{dm}) est estimée par la détection d'un change de modèle (M₁, M₂) du courant différentiel résiduel de mesure (I_{dm}).
